Europäisches Patentamt

**European Patent Office**

Office européen des brevets

(19)

(11) **EP 1 131 643 B1**

(12) **EUROPÄISCHE PATENTSCHRIFT**

(45) Veröffentlichungstag und Bekanntmachung des Hinweises auf die Patenterteilung:
**05.02.2003 Patentblatt 2003/06**

(21) Anmeldenummer: **99960907.6**

(22) Anmeldetag: **16.11.1999**

(51) Int Cl.$^7$: **G01R 31/11**, G01R 27/06

(86) Internationale Anmeldenummer:
**PCT/DE99/03650**

(87) Internationale Veröffentlichungsnummer:
**WO 00/029862 (25.05.2000 Gazette 2000/21)**

(54) **VERFAHREN ZUR KORREKTUR DER FREQUENZ- UND LÄNGENABHÄNGIGEN LEITUNGSDÄMPFUNG BEI FDR-MESSUNGEN AN HOCHFREQUENZKABELN**

METHOD FOR CORRECTING FREQUENCY- AND LENGTH-DEPENDENT LINE ATTENUATION FOR FDR-MEASUREMENTS CARRIED OUT ON HIGH-FREQUENCY CABLES

PROCEDE DE CORRECTION DE L'AFFAIBLISSEMENT DE LIGNE FONCTION DE LA FREQUENCE ET DE LA LONGUEUR DANS LE CAS DE MESURES PAR REFLECTOMETRIE EN DOMAINE FREQUENTIEL EFFECTUEES SUR DES CABLES HAUTE FREQUENCE

(84) Benannte Vertragsstaaten:
**AT BE CH FR GB LI**

(30) Priorität: **16.11.1998 DE 19852086**

(43) Veröffentlichungstag der Anmeldung:
**12.09.2001 Patentblatt 2001/37**

(73) Patentinhaber: **T-Mobile Deutschland GmbH 53227 Bonn (DE)**

(72) Erfinder:
  • **NOWOK, Gregor D-90455 Nürnberg (DE)**
  • **POSPIECH, Peter D-91330 Eggolsheim (DE)**

(74) Vertreter: **Riebling, Günter, Dr. Patentanwalt Dr.-Ing. P. Riebling, Postfach 31 60 88113 Lindau (DE)**

(56) Entgegenhaltungen:
  **EP-A- 0 768 537        US-A- 4 630 228**

  • **DONG C: "FREQUENCY DOMAIN REFLECTOMETRY: AN OLD CONCEPT WITH A NEW APPLICATION" MICROWAVE JOURNAL,US,HORIZON HOUSE. DEDHAM, Bd. 39, Nr. 7, 1. Juli 1996 (1996-07-01), Seite 124,126,128,13 XP000679082 ISSN: 0192-6225**

**Beschreibung**

Die Erfindung betrifft ein Verfahren zur Korrektur der frequenzabhängigen Leitungsdämpfung bei FDR-Messungen an Hochfrequenzkabeln nach den Merkmalen des Oberbegriffs des Patentanspruchs 1.

Das Reflektionsverhalten von Leitungen und Leitungsübergängen bei Kabeln wird mittels TDR (Time Domain Reflectometry) bzw. FDR (Frequency Domain Reflectometry)-Messgeräten ermittelt. Damit lassen sich Fehlerstellen in Kabeln, Leitungen und Leitungssystemen, insbesondere an Leitungsübergängen, bestimmen und genau lokalisieren. Die Messung am Kabel oder Leitungssystem erfolgt im Frequenzbereich, wobei die erfassten Messwerte mittels umgekehrter Fouriertransformation in den Zeitbereich abgebildet werden. Die derzeit käuflichen Messgeräte arbeiten ohne Korrektur bzw. nur mit schmalbandiger Korrektur der frequenz- und längenabhängigen Leitungsdämpfung der gemessenen Kabel. Die individuelle frequenz- und längenabhängige Dämpfung des Kabels verfälscht die Messergebnisse und erschwert es, tatsächliche Fehlerquellen mit Sicherheit zu erkennen bzw. die Güte der Leitungsanpassung zu beurteilen. Im Interesse eines guten Messergebnisses, d.h. einer sehr guten Auflösung im Zeitbereich, sollten die Messungen im Frequenzbereich breitbandig ausgeführt werden. Eine derartige breitbandige Messung führt jedoch ohne bzw. ohne umfassende Korrektur der frequenz- und längenabhängigen Leitungsdämpfung der gemessenen Kabel zu erheblichen Messfehlern.

Ein Verfahren zur Analyse von Übertragungsleitungen zur automatischen Identifikation von Leitungsfehlern und Fehlanpassungen ist in der US-A-4 630 228 beschrieben. Hierbei wird anhand einer FDR-Messung ein komplexes, zusammengesetztes und zeitveränderliches Signal erzeugt, das eine Ortsinformation eines Leitungsfehlers enthält. Das Signal wird einer Fast Fourier Transformation (FFT) unterzogen, wobei anhand des erhaltenen Spektrums der Ort der Fehlerstelle bestimmt werden kann.

Die EP-A-0 768 537 lehrt ein auf Impulsen basierendes Impedanzmessgerät, mittels dem basierend auf einem Signal im Zeitbereich, das mittels FFT in den Frequenzbereich transformiert wird, die komplexe Impedanz als auch die Rückflußdämpfung über die Frequenz ermittelt werden kann.

In einem Artikel von DONG C.: "Frequency Domain Reflectometry: An Old Concept With A New Application" in Microwave Journal, July 1996, US Horizon House Dedham, Bd. 39, Nr. 7, Seiten 124-132, XP 000679082, ISSN 0192-6225 wird ebenfalls der Einsatz des bekannten FDR-Verfahrens zur Fehlermessung auf Übertragungsleitungen und Antennen beschrieben.

Die Schriften zum Stand der Technik befassen sich jedoch nicht mit dem Problem der individuellen frequenz- und längenabhängigen Dämpfung eines Kabels, welche die Messergebnisse verfälscht.

Die Aufgabe der Erfindung liegt deshalb darin, ein Verfahren zur Korrektur der frequenzabhängigen Leitungsdämpfung bei Messungen an Hochfrequenzkabeln vorzuschlagen, mit welchem bei breitbandiger Messung wesentlich genauere Messwerte über den gesamten Längenbereich des Kabels erzielt werden können.

Gelöst wird diese Aufgabe durch die kennzeichnenden Merkmale des Patentanspruchs 1.

Die Erfindung beruht darauf, daß für jeden zu messenden Kabeltyp aus vom Hersteller vorgegeben Dämpfungswerten ein Parametersatz für ein Dämpfungsmodell erzeugt wird. Anhand dieses Dämpfungsmodells lässt sich im Zeitbereich eine längenabhängige Korrekturfunktion angeben, mir der dann die ebenfalls in den Zeitbereich transformierten Messwerte des komplexen Reflektionsfaktors korrigiert werden, wobei sich physikalisch richtige Werte ergeben.

Dadurch wird der Vorteil erreicht, daß die Fehler der Messungen im Frequenzbereich, hervorgerufen durch eine frequenzabhängige und längenabhängige Leitungsdämpfung, im Zeitbereich korrigiert werden und die resultierenden Messergebnisse erheblich genauer werden.

Damit ist der weitere Vorteil gegeben, daß eine breitbandige Korrektur des frequenz- und längenabhängigen Fehlers über den gesamten betrachteten Frequenzbereich $f_0$ bis $f_{max}$ erzielt werden kann.

Vorteilhafte Ausgestaltungen und Weiterbildungen der Erfindung sind Gegenstand der abhängigen Patentansprüche.

So ist z.B. vorgesehen, zur Impulsformung der Werte des komplexen Reflektionsfaktors R(f) im Frequenzbereich ein Impulsformungsfilter anzuwenden, um seitliche Überschwinger im Messignal zu unterdrücken.

Nachfolgend wird die Erfindung anhand eines Ausführungsbeispiels unter Bezugnahme auf Zeichnungen näher erläutert. Dabei gehen aus den Zeichnungen und ihrer Beschreibung weitere Merkmale und Vorteile der Erfindung hervor.

Figur 1 zeigt ein Blockschaltbild zur erfindungsgemässen Korrektur der längenund frequenzabhängigen Leitungsdämpfung bei FDR-Messungen an Leitungssystemen;

Figur 2 zeigt ein Blockschaltbild zur erfindungsgemässen Korrektur der längenund frequenzabhängigen Leitungsdämpfung bei FDR-Messungen an Leitungssystemen mit Pulsformungsfilter;

Figur 3 zeigt ein Blockschaltbild einer möglichen Anwendung des erfindungsgemässen Verfahrens.

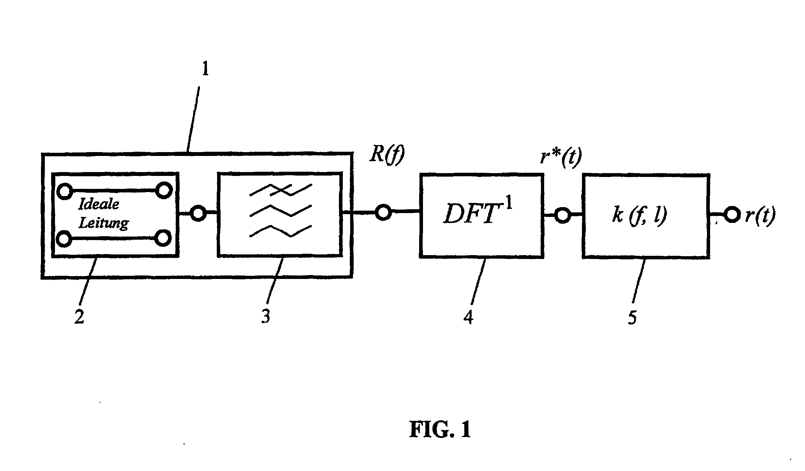

Figur 1 zeigt schematisch ein Blockschaltbild einer zu messenden Hochfrequenzleitung 1. Ausgehend von einer idealen Leitung 2 weist jede Leitung eine definierte frequenz- und längenabhängigen Dämpfung 3 auf, die durch eine zu bestimmende Näherungsfunktion beschrieben werden kann.

Näherungsfunktion für die frequenzabhängige Dämpfung Die Leitungsdämpfung für eine vorgegebene Länge und Frequenz wird an einer an einem Ende kurzgeschlossenen Leitung bestimmter Länge ermittelt. Für eine kurzgeschlossene Leitung der Länge $l_0$ läßt sich der Eingangsreflektionsfaktor $r(f,l_0)$ folgendermaßen angeben:

$$r(f,l_0) = -1 \cdot e^{-2 \cdot [\alpha(f) + j \cdot \beta(f)] \cdot l_0} \tag{1}$$

mit $\alpha(f)$.....Dämpfung, als Funktion der Frequenz
$\beta(f)$................Phase als Funktion der Frequenz

Der Betrag ist somit:

$$\left| r(f,l_0) \right| = e^{-2 \cdot \alpha(f) \cdot l_0} \tag{2}$$

Der Returnloss $a_R(f,l_0)$ stellt die doppelte Leitungsdämpfung dar und ergibt sich zu:

$$2 \cdot a_R(f,l_0) = 20 \cdot 1g\{\left| r(f,l_0) \right|\} = \frac{-40}{\ln(10)} \cdot \alpha(f) \cdot l_0 \tag{3}$$

Die Kabelhersteller geben in der Regel die Leitungsdämpfung für fünf bestimmte Frequenzen an. Die Funktion der einfachen Kabeldämpfung $a_{R_N}(f,l_0)$ über der Frequenz läßt sich sehr gut durch folgende Funktion annähern:

$$a_{R_N}(f,l_0) = a \cdot f^b \cdot l_0 \tag{4}$$

Durch Gleichsetzen der beiden Ausdrücke $a_{R_N}(f,l_0)$ und $a_R(f,l_0)$, d.h. der Gleichungen (3) und (4), erhält man die frequenzabhängige Dämpfung $\alpha(f)$, die sich ergibt zu:

$$\alpha(f) = -\frac{\ln(10)}{20} \cdot a \cdot f^b \tag{5}$$

Die Konstanten $a$ und $b$ sind leitungsspezifische Parameter. Diese können durch die Methode der kleinsten Fehlerquadrate bestimmt werden.

Misst man nun den komplexen Reflektionsfaktor R(f) des betrachteten Kabels 1 in äquidistanten Schritten über einen Frequenzbereich $f_0$ - $f_{max}$, so erhält man eine Reihe von Messwerten $R_1(f)$ - $R_n(f)$, die durch eine diskrete Fouriertransformation 4 in den Zeitbereich transformiert werden können. Man erhält den komplexen Reflektionsfaktor r*(t). Dieser Reflektionsfaktor im Zeitbereich ist fehlerbehaftet, hervorgerufen durch die frequenz- und längenabhängige Dämpfung des gemessenen Kabels 1. Um diese Fehler auszugleichen, wird nun erfindungsgemäss vorgeschlagen, eine Korrektur 5 auf die Messwerte r*(t) anzuwenden. Damit erhält man berichtigte Messwerte, unabhängig von der kabelspezifischen Dämpfung. Die Korrektur 5 erfolgt durch eine Korrekturfunktion $k_D(f, l)$.

Bedingung für eine Korrekturfunktion im Zeitbereich:

Werden für die Bestimmung der Systemfunktion (komplexer Reflektionsfaktor im Frequenzbereich) idealerweise alle Frequenzen von 0 bis Unendlich herangezogen, so ergibt der Reflektionsfaktor im Zeitbereich (nach vorheriger Fouriertransformation) einen Delta-Impuls an der Stelle $\frac{2 \cdot l_0}{c \cdot v}$, mit c als Lichtgeschwindigkeit und $v_k$ als Verkürzungsfaktor der Leitung. Dieser Impuls hätte im Idealfall ohne Leitungsdämpfung die Amplitude 1, wird aber durch die frequenzabhängige Dämpfung auf einen kleineren Wert abgebildet.

Durch formale Einführung einer Korrekturfunktion $k_D(f,l_0)$ läßt sich der Delta-Impuls auf den Wert 1 bringen.

Aus den vorherigen Aussagen kann folgende Bedingung angesetzt werden:

$$-\delta(t - \frac{2 \cdot l_0}{c \cdot v_k}) = k_D(f, l_0) \cdot \int_0^{f_{max}} -1 \cdot e^{\frac{\ln(10)}{10} \cdot a \cdot f^b \cdot l_0} \cdot e^{j \cdot 2 \cdot \pi \cdot (t - \frac{2 \cdot l_0}{c \cdot v_k})} \cdot df$$

oder im Fall $t = \frac{2 \cdot l_0}{c \cdot v_k}$

$$|k_D(f, l_0)| = \frac{1}{\int_0^{f_{max}} e^{\frac{\ln(10)}{10} \cdot a \cdot f^b \cdot l_0} \cdot df} \qquad \cdot (6)$$

Für jeden Wert r*(t) lässt sich nun ein Wert der Korrekturfunktion $f_D$(f, l) angeben. Durch Multiplikation der Werte des Reflektionsfaktors r*(t) mit den entsprechenden Werten der Korrekturfunktion $k_D$(f, l) erhält man nun einen dämpfungskorrigierten Wert r(t) des Reflektionsfaktors.

Lösung des Integrals in Gleichung (6):

Für das im Nenner von Gleichung (6) stehende Integral existiert keine Stammfunktion, deswegen erfolgt die Lösung durch Reihenentwicklung.
Da die Reflektionsstellen in der Systemfunktion als Summe erscheinen, kann vom speziellen Fall des Kurzschlusses auf eine Leitung mit mehreren Fehlerstellen verallgemeinert werden. Durch Ersetzung des Parameters $l_0$ durch $l$ kann jeder Bildpunkt im Zeitbereich korrigiert werden.

$$|k_D(f, l)| = \frac{b}{\sum_{v=0}^{v_{max}} \frac{[\frac{\ln(10)}{10} \cdot a \cdot l \cdot f_{max}^b]^v}{v! \cdot (v + \frac{1}{b})}} \qquad (7)$$

Die durch Fouriertransformation gewonnene Zeitfunktion wird mit der Korrekturfunktion multipliziert. Die in der Zeitfunktion dargestellten Reflektionsstellen werden dadurch dämpfungskorrigiert.

Verwendung eines Cosinus-Filters zur Imputsformung;

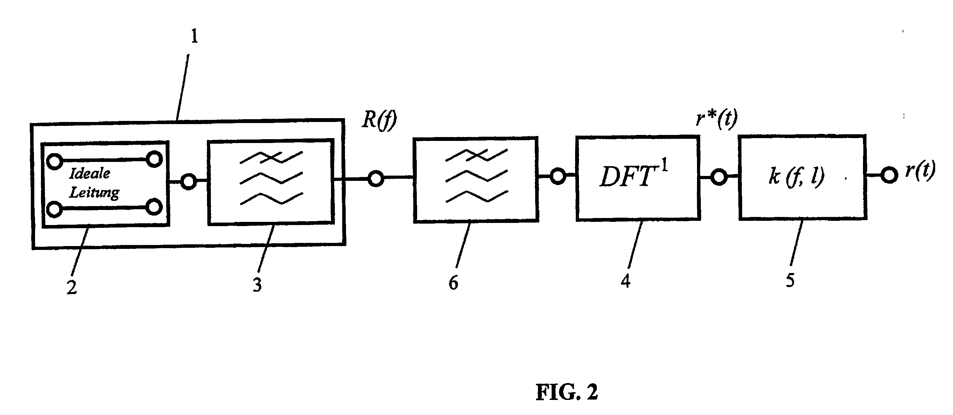

In einer bevorzugten Ausführungsform der Erfindung ist es gemäss Figur 2 vorgesehen, zur Impulsformung der Werte des komplexen Reflektionsfaktors R(f) im Frequenzbereich ein Impulsformungsfilter 6 anzuwenden. Grund dafür ist, dass die Rücktransformation der Meßwerte aus einem bis $f_{max}$ beschränkten Frequenzbereich den Nachteil hat, daß anstatt eines δ-Impulses eine $\frac{\sin x}{x}$ - Funktion die Reflektionsstelle beschreibt. Diese $\frac{\sin x}{x}$ - Funktion hat die Eigenschaft, daß die seitlichen Überschwinger des Signals nahegelegene andere Reflektionsstellen beeinflussen. Um diese Überschwinger möglichst klein zu halten, bzw. ganz zu beseitigen, ist es üblich, die Frequenzdaten mit einem Cosinus-Impulsformungsfilter 6 zu versehen. Diese Filter haben folgende allgemeine Darstellung im Frequenzbereich:

$$F(f) = C_0 + C_1 \cdot \cos(\frac{\pi \cdot f}{f_{max}}) + C_2 \cdot \cos(\frac{2 \cdot \pi \cdot f}{f_{max}}) \tag{8}$$

Dieses Filter wird im Frequenzbereich mit den Werten des Reflektionsfaktors R(f) multipliziert und ergibt somit ein neues Filter. Unter Beachtung der im Punkt 2 erwähnten Argumentationskette kann nun ausgehend von Gleichungen (6) und (8) folgende Bedingung für die Korrekturfunktion $k_D(f, I)$ angeschrieben werden.

$$|k_D(f, l_0)| = \frac{1}{\left| \int_0^{f_{max}} F(f) \cdot e^{\frac{\ln(10)}{10} \cdot a \cdot f^b \cdot l_0} \cdot df \right|} \tag{9}$$

Lösung des Integrals in Gleichung (9):

Das im Nenner stehende Integral wird in drei Teilintegrale aufgespaltet, die ihrerseits nur durch Reihenentwicklung lösbar sind.

$$|k_D(f, l_0)| = \frac{1}{|k_0(f, l_0) + k_1(f, l_0) + k_2(f, l_0)|}$$

Die Lösungen der Teilintegrale lauten folgendermaßen:

$$k_0(f, l_0) = C_0 \cdot \sum_{p=0}^{p_{max}} \frac{\left[ -2 \cdot \frac{\ln 10}{20} \cdot a \cdot l_0 \right]^p}{p!} \cdot \frac{f_{max}^{p \cdot b}}{p \cdot b + 1}$$

$$k_1(f, l_0) = C_1 \cdot \sum_{p=0}^{p_{max}} \sum_{q=0}^{p} \frac{(j \cdot \frac{\pi}{f_{max}})^{2 \cdot q} \cdot \left[ -2 \cdot \frac{\ln 10}{20} \cdot a \cdot l_0 \right]^{(p-q)}}{(2 \cdot p)! \cdot (p-q)!} \cdot \frac{f_{max}^{[2 \cdot q + (p-q) \cdot b]}}{2 \cdot q + 1 + (p-q) \cdot b}$$

$$k_2(f, l_0) = C_2 \cdot \sum_{p=0}^{p_{max}} \sum_{q=0}^{p} \frac{(j \cdot \frac{2 \cdot \pi}{f_{max}})^{2 \cdot q} \cdot \left[-2 \cdot \frac{\ln 10}{20} \cdot a \cdot l_0\right]^{(p-q)}}{(2 \cdot p)! \cdot (p-q)!} \cdot \frac{f_{max}^{[2 \cdot q + (p-q) \cdot b]}}{2 \cdot q + 1 + (p-q) \cdot b}$$

Die durch Fouriertransformation gewonnene Zeitfunktion r*(t) wird mit der Korrekturfunktion $k_D$(f, l) multipliziert. Die in der Zeitfunktion dargestellten Reflektionsstellen werden dadurch dämpfungskorrigiert, außerdem werden die Überschwinger unterdrückt.

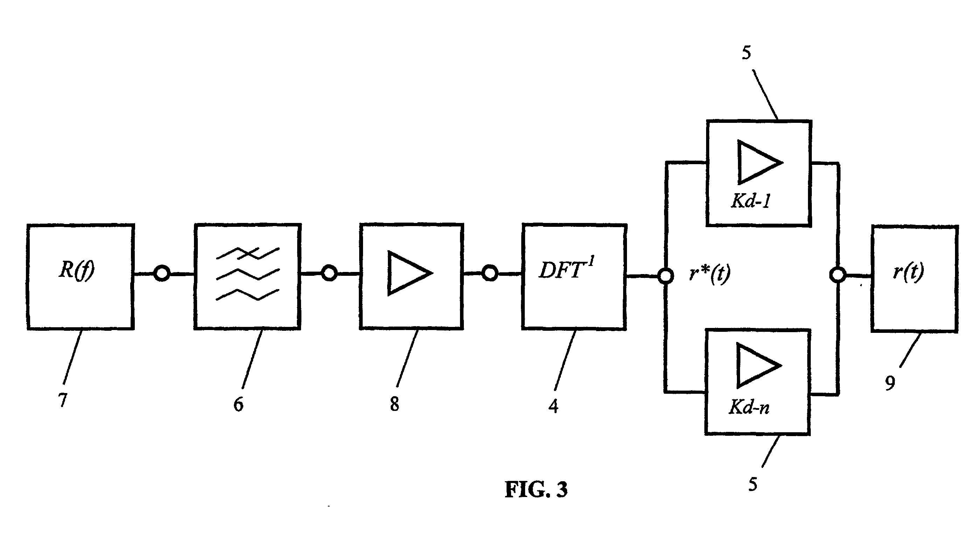

Figur 3 erläutert nochmals die Anwendung des erfindungsgemässen Verfahrens. Der komplexe Reflektionsfaktor R(f) eines Kabels wird im Frequenzbereich $f_0$ - $f_{max}$ in äquidistanten Frequenzschritten gemessen und die erhaltenen Messwerte 7 abgespeichert. Die Messung erfolgt mit einem handelsüblichen FDR-Messgerät. Die Messwerte werden anschliessend an einen Personalcomputer übertragen und dort abgespeichert. Die weitere Verarbeitung der Messwerte erfolgt durch den Personalcomputer. Zunächst werden die Messwerte im Frequenzbereich durch ein Impulsformungsfilter 6 korrigiert um die seitlichen Überschwingen zu unterdrücken.
Nach einer optionalen Verstärkung 8 der tiefen Frequenzen zur Korrektur der Energiebilanz erfolgt die Transformation 4 der Messwerte R(t) vom Frequenzbereich in den Zeitbereich r*(t) durch Anwendung der diskreten Fouriertransformation. Anhand der zuvor ermittelten Korrekturfunktion $k_D$(f, l) 5 für das gemessene Kabel werden nun die Messwerte r*(t) mit den entsprechenden Korrekturwerten kd-1 bis kd-n der Korrekturfunktion $k_D$(f, l) multipliziert, so daß sich ein dämpfungskorrigiertes Ergebnissignal r(t) 7 im Zeitbereich ergibt, das abgespeichert und in geeigneter Weise numerisch und/oder graphisch dargestellt werden kann.

**Patentansprüche**

1. Verfahren zur Korrektur der frequenzabhängigen Leitungsdämpfung bei FDR-Messungen an Hochfrequenzkabeln und -leitungen, **gekennzeichnet durch** folgende Schritte:

    Ermitteln des längenabhängigen Dämpfungsverlaufs ($a_{Rn}$) des zu messenden Kabels über den gesamten zu messenden Frequenzbereich;
    Ermitteln einer Korrekturfunktion ($k_D$(f,l)) zur Korrektur des ermittelten Dämpfungsverlaufs ($a_{Rn}$);
    Ermitteln des komplexen Reflektionsfaktors R(f) des zu messenden Kabels im Frequenzbereich in äquidistanten Frequenzabständen;
    Fouriertransformation der Messwerte des komplexen Reflektionsfaktors R(f) in entsprechende Messwerte r*(t) im Zeitbereich;
    Korrektur der transformierten Werte r*(t) mit Hilfe der Korrekturfunktion $k_D$(f,l); zu korrigierten Messwerten r(t).

2. Verfahren nach Anspruch 1, **dadurch gekennzeichnet, daß** der Dämpfungsverlauf ($a_{Rn}$) des Kabels anhand kabelspezifischer Parameter a,b durch Messung an einem Kabel einer bestimmten Länge ermittelt wird.

3. Verfahren nach Anspruch 1 oder 2, **dadurch gekennzeichnet, daß** die für beliebige Kabellängen gültige Korrekturfunktion aus den kabelspezifischen Parametern a,b ermittelt wird.

4. Verfahren nach einem der Ansprüche 1 - 3, **dadurch gekennzeichnet, daß** der komplexe Reflektionsfaktor R(f) durch Anlegen eines Sinussignals an das zu messende Kabel über einen Frequenzbereich $f_0$ - $f_{max}$ in äquidistanten Frequenzabständen ermittelt wird.

5. Verfahren nach einem der Ansprüche 1 - 4, **dadurch gekennzeichnet, daß** die Messwerte des Reflektionsfaktors R(f) im Frequenzbereich mit einem Cosinus-Impulsformungsfilter multipliziert werden.

6. Verfahren nach einem der Ansprüche 1 - 5, **dadurch gekennzeichnet, daß** die korrigierten Messwerte abgespeichert und/oder numerisch oder graphisch dargestellt werden.

**Claims**

1.  Method for the correction of frequency-dependent line attenuation in FDR measurements on high-frequency cables and lines, **characterised by** the following steps:

    determination of the length-dependent attenuation curve ($a_{Rn}$) of the cable to be measured throughout the frequency range to be measured;
    determination of a correction function ($k_D\{f,l\}$) for correction of the measured attenuation curve ($a_{Rn}$) ;
    determination of the complex reflection factor R(f) of the cable to be measured in the frequency range at equidistant frequency intervals;
    Fourier transformation of the measured values of the complex reflection factor R(f) into corresponding measured values r*(t) in the time range;
    correction of the transformed values r*(t) by means of the correction function $k_D$(f,1) into corrected measured values r(t).

2.  Method according to claim 1, **characterised in that** the attenuation curve ($a_{Rn}$) of the cable is determined with the aid of cable-specific parameters a, b by measurement on a cable having a given length.

3.  Method according to claim 1 or 2, **characterised in that** the correction function applicable to any cable lengths is determined from the cable-specific parameters a, b.

4.  Method according to one of claims 1 - 3, **characterised in that** the complex reflection factor R(f) is determined by applying a sine signal to the cable to be measured over a frequency range $f_0$ - $f_{max}$ at equidistant frequency intervals.

5.  Method according to one of claims 1 - 4, **characterised in that** the measured values of the reflection factor R(f) in the frequency range are multiplied with a cosine pulse shaping filter.

6.  Method according to one of claims 1 - 5, **characterised in that** the corrected measured values are stored and/or digitally or graphically displayed.


**Revendications**

1.  Procédé pour corriger l'affaiblissement de conduction dépendant de la fréquence, lors de mesures FDR (réflectométrie dans le domaine fréquentiel) sur des câbles et lignes haute fréquence, **caractérisé par** les étapes suivantes :

    -   calcul de la courbe d'affaiblissement dépendant de la longueur ($a_{Rn}$) du câble à mesurer, dans tout le domaine fréquentiel à mesurer ;
    -   calcul d'une fonction de correction ($k_D$(f,l)) pour corriger la courbe d'affaiblissement ($a_{Rn}$) déterminée ;
    -   calcul du facteur de réflexion complexe R(f) du câble à mesurer dans le domaine fréquentiel à des intervalles de fréquence équidistants ;
    -   transformation de Fourier des valeurs de mesure du facteur de réflexion complexe R(f) en valeurs de mesure correspondantes r*(t) dans le domaine temporel ;
    -   correction des valeurs transformées r*(t) à l'aide de la fonction de correction $k_D$(f,l) en valeurs de mesure corrigées r(t).

2.  Procédé selon la revendication 1, **caractérisé en ce que** la courbe d'affaiblissement ($a_{Rn}$) du câble est calculée à l'aide de paramètres a, b spécifiques du câble grâce à une mesure sur un câble d'une longueur définie.

3.  Procédé selon la revendication 1 ou 2, **caractérisé en ce que** la fonction de correction valable pour des longueurs de câble quelconques est calculée à partir des paramètres a, b spécifiques du câble.

4.  Procédé selon l'une des revendications 1 à 3, **caractérisé en ce que** le facteur de réflexion complexe R(f) est calculé grâce à l'application d'un signal sinus au câble à mesurer, dans un domaine fréquentiel $f_0$-$f_{max}$ à des intervalles de fréquence équidistants.

5.  Procédé selon l'une des revendications 1 à 4, **caractérisé en ce que** les valeurs de mesure du facteur de réflexion R(f) dans le domaine fréquentiel sont multipliées par un filtre de conformation d'impulsions cosinus.

6. Procédé selon l'une des revendications 1 à 5, **caractérisé en ce que** les valeurs de mesure corrigées sont mises en mémoire et/ou représentées sous forme numérique ou graphique.

r(t)

k (f, l)

5

r*(t)

DFT⁻¹

4

R(f)

Ideale Leitung

1

3

2

FIG. 1

FIG. 2

FIG. 3